# EUROPÄISCHE PATENTSCHRIFT

(11) **EP 0 926 264 B1**
(45) Veröffentlichungstag und Bekanntmachung des Hinweises auf die Patenterteilung: **12.05.2004**
(21) Anmeldenummer: 98123669.8
(22) Anmeldetag: 11.12.1998
(51) Int. Cl.: C23C 18/31

(54) **Austausch-Zinnbad**
Displacement tin bath
Bain pour l'étamage par déplacement

(30) Priorität: 11.12.1997 DE 19755185
(43) Veröffentlichungstag der Anmeldung: 30.06.1999
(73) Patentinhaber: AMI Doduco GmbH, 75181 Pforzheim (DE)
(72) Erfinder: Macht, Walter, 75180 Pforzheim (DE)
(74) Vertreter: Twelmeier, Ulrich, Dipl.Phys.

(56) Entgegenhaltungen:
- US-A- 5 196 053
- DATABASE WPI Section Ch, Week 198844 Derwent Publications Ltd., London, GB; Class E19, AN 1988-312397 XP002165987 & JP 63 230883 A (SHINKO DENKI KOGYO KK), 27. September 1988 (1988-09-27)

## Beschreibung

Die Erfindung befaßt sich mit einem wäßrigen, stark sauren Austauschbad zum stromlosen Abscheiden von Zinn auf Kupfer.

Solche Bäder sind aus Dr. Manfred Jordan: Die galvanische Abscheidung von Zinn und Zinnlegierungen, Eugen G. Leuze Verlag Saulgau/Württ. erschienen 1993 bekannt. Bei der Austauchreaktion gibt das zu beschichtende Substratmaterial, hier Kupfer, Elektronen an Zinnionen ab und geht dabei selbst in Lösung. Diese Reaktion läuft jedoch nur ab, wenn das elektrochemische Potential des Substratmetalls unedler ist als das der Zinnionen in der jeweiligen Lösung. Bei Kupfer ist dies nicht der Fall, so daß ein Komplexbildner zugesetzt werden muß, der das Potential für Kupfer in negative Richtung verschiebt. Die Abscheidung erfolgt zunächst bevorzugt an aktiven Zentren des Substrats, z.B. entlang von Komgrenzen, und breitet sich dann auf die gesamte Oberfläche aus. Die Austauschreaktion kommt zum Stillstand, wenn das Basismaterial vollständig bedeckt ist. Damit sind Schichtdicken von bis zu 1 µm erreichbar. Zur Verschiebung des elektrochemischen Potentials des Substratmetalls wird Thioharnstoff verwendet. Aus der genannten Literatur sind als Grundelektrolyt Sulfonsäuren, z.B. Alkylsulfonsäure, Schwefelsäure und HBF₄ bekannt. Zur besseren Benetzung der Oberfläche des Substratmetalls werden Alkyl- und Alkylphenol-Naphtholethoxylate, Alkylphenol- und Nonylphenol-Ethoxylate, Ethoxylat-Addukte, Polyethylenoxid, Fettalkohole und Fettamine verwendet. Als Kornverfeinerer sind beispielsweise bekannt: Formaldehyd, Nikotinsäurederivate, Benzalaceton (4-Phenyl-3-buten-2-on), aromatisches Amin, kurzkettige ungesättigte Carbonsäuren, Diaminotriazinderivate und Butylalkoholethoxylate. Zur Erzielung brauchbarer Zinnschichten müssen diese Bäder bei einer Temperatur von 50 bis 70 °C gefahren werden. Bei diesen Temperaturen findet jedoch vermehrt eine Oxidation des Thioharnstoffs zum Sulfat und Schwefel statt, so daß es zu einer Anreicherung von elementarem Schwefel im Bad kommt. Der Schwefel schlägt sich dann auf den Leiterplatten nieder und verhindert eine gleichmäßige reine Zinnschichtbildung. Durch den Einsatz von Titan-III-Chlorid als Reduktionsmittel kann die erreichbare Schichtdicke erhöht werden auf etwa 3 bis 4 µm in 20 Minuten. Hierbei handelt es sich jedoch nicht um eine Austauschreaktion, sondern das Zinn (II) wird zu Zinn (0) reduziert, indem es die Elektronen vom Reduktionsmittel erhält. Die bekannten reduktiven Bäder sind jedoch nicht stabil.

Aufgabe der Erfindung ist es deshalb, ein Bad zu entwickeln, das nahezu keinen Schwefelniederschlag erzeugt, eine porenfreie Zinnschicht ausbildet und trotzdem stabil gefahren werden kann.

Die Aufgabe wird durch ein Austausch-Zinnbad mit der Zusammensetzung nach Anspruch 1 erfüllt. Vorteilhafte Weiterbildungen der Erfindung sind Gegenstand der Unteransprüche.

Unter einem stark sauren Bad wird im Rahmen dieser Anmeldung ein Bad mit einem pH-Wert kleiner 1,0 verstanden.

Erfindungsgemäß werden 5 bis 30 g Zinn pro 1 Liter Badflüssigkeit in Form eines Zinn-ll-Salzes verwendet, wobei bevorzugt Zinnmethansulfonat und besonders bevorzugt Zinn-Sulfat oder -Chlorid verwendet wird. Verbindungen des Zinns mit anderen Anionen wären auch möglich, sind jedoch sehr teuer und bieten keinen technologischen Vorteil und spielen deshalb nur eine untergeordnete Rolle. Bei einer Unterschreitung der Untergrenze der angegebenen Zinnkonzentration stehen nur wenig Zinnionen zur Verfügung, so daß, um eine akzeptable Abscheiderate zu erhalten, das Bad häufig bezüglich der Zinnkonzentration überwacht werden muß und immer wieder Zinnionen nachdosiert werden müssen. Dies ist sehr mühsam, aufwendig und kostenintensiv. Bei einer Überschreitung der Obergrenze erreicht man bald den Löslichkeitsgrenzwert, der abhängig von der verwendeten Säure und dem pH-Wert ist. Außerdem steigen die Kosten je höher die Zinnkonzentration ist und die Abwasserbelastung, wenn das Bad nach einer gewissen Zeit, wenn der Kupfergehalt einen kritischen Wert überschreitet, verworfen werden muß.

Erfindungsgemäß werden 50 bis 200 g pro Liter Badflüssigkeit Thiohamstoff oder eines Derivats davon für das Austauschbad verwendet. Durch den Thioharnstoff oder ein Derivat davon wird das Standardpotential für Kupfer zu negativen Werten verschoben, und das Kupfer wird dadurch komplexiert werden, und dadurch eine Austauschreaktion mit dem unedleren Zinn überhaupt erst ermöglicht. Bei einer Erhöhung der Konzentration über 200 g pro Liter wird die Löslichkeitsgrenze erreicht. Bei einer niedrigeren Konzentration als 50 g pro Liter geht die Abscheiderate um die oxidative Zersetzung des Thioharnstoffs oder seines Derivats in Schwefel zurück, da nicht mehr das gesamte durch das Zinn ausgetauschte Kupfer komplexiert werden kann.

Um eine Oxidation des Thioharnstoffs oder seines Derivats zu freiem Schwefel zu unterdrücken, ist dem Bad erfindungsgemäß 1 bis 10 g 2-Thiohydantoin pro Liter Badflüssigkeit als Stabilisator zugesetzt. Die Konzentration des Stabilisators ist eng verbunden mit der Konzentration des Thioharnstoffs oder seines Derivats.

Auch hier stößt man bei einer Überschreitung der angegebenen maximalen Konzentration an seine Löslichkeitsgrenze, bei einer Unterschreitung der angegebenen minimalen Konzentration setzt eine Niederschlagsbildung ein, indem der Thioharnstoff oxidativ zersetzt wird und elementarer Schwefel ausfällt.

Der erfindungsgemäß pro 1 Liter Badflüssigkeit zugesetzte Feinkornzusatz in einer Konzentration von 0,5 bis 2 g der Wirksubstanz dient dazu, daß sich das Zinn beim Abscheiden feinkörniger auf der Oberfläche der Leiterplatte verteilt. Die feine Verteilung des Zinns wird erst während des Austausches mit den Kupferatomen der Leiterplatte bewirkt, nicht schon währenddem das Zinn in Lösung ist. Der Einbau des Zinns in das Kupfersubstrat geht so vor sich, daß am Anfang eine Kavernenbildung erfolgt, wodurch an der Oberfläche immer noch Bereiche mit Kupfer vorhanden sind. Der Austausch von Zinn gegen Kupfer geht so lange weiter, bis keine Kupferatome mehr an der Oberfläche des Substrats vorhanden sind. Durch die Zugabe des Feinkornzusatzes werden die Austauschbereiche kleiner und somit können die Kavernen besser geschlossen werden, was dazu führt, daß die Zinnschicht gleichmäßiger und kompakter ausgebildet und in der Folge ein Diffundieren einer Kupfer-Zinn-Phase an die Oberfläche unterdrückt wird. Dadurch wird eine Oxidation an der Oberfläche vermieden. Bei der Entstehung einer oxidierten Kupfer-Zinn-Phase an der Oberfläche, wäre diese nicht mehr lötbar. Bei einer Unterschreitung der Minimalkonzentration des Feinkornzusatzes kommt es zu einer grobkörnigen Abscheidung des Zinns, wodurch die Porigkeit der Zinnoberfläche erhöht wird, so daß sie sich nicht mehr als Diffusionsbarriere eignet Wird die Obergrenze der angegebenen Konzentration des Feinkornzusatzes überschritten, tritt keine Verbesserung bezüglich der feinkörnigen Verteilung des Zinns auf der Oberfläche ein, jedoch steigen die Kosten sehr stark an. Bevorzugt werden als Feinkornzusatz Benzalaceton, Benzalacetonderivate oder ein Immidazol, wobei als Benzalacetonderivat besonders bevorzugt Benzyliden-Diacetonol oder p-Chlorbenzyliden-Diacetonol verwendet wird.

Um den Feinkornzusatz und die Zinnionen möglichst gleichmäßig und über die gesamte Oberfläche, die üblicherweise vorher gereinigt und schwach geätzt wurde, mit dieser in Berührung zu bringen, wird erfindungsgemäß pro 1 Liter Badflüssigkeit 1 bis 20 ml eines Tensides beigegeben. Dieses Tensid setzt die Oberflächenspannung des Bades herab und intensiviert damit die Benetzung der Oberfläche des Substrats mit Badflüssigkeit. Eine höhere Konzentration führt zu einer erhöhten Schaumbildung, eine niedrigere dagegen zu einer schlechteren Benetzung der zu beschichtenden Oberfläche. Als Netzmittel wird bevorzugt ein Fettalkoholether, ein Fettsäureamid, ein Ölsäureamidethoxylat, ein Alkylphenol oder ein Polyethylenglykol verwendet. Besonders bevorzugt wird ein ethoxylierter Fettalkoholether verwendet, der eine Kohlenstoffkettenlänge von 10 bis 14 hat.

Sollte der Feinkornzusatz nicht wasserlöslich sein, so muß dem Austauschbad erfindungsgemäß ein Emulgator zugegeben werden, der den Feinkornzusatz in dem Bad fein verteilt. Die Konzentration des Emulgators hängt davon ab, welcher Feinkornzusatz emulgiert werden soll, wie hoch seine Konzentration ist und welcher Emulgator verwendet wird. Erfindungsgemäß liegt die Konzentration in einem Bereich von 1-20 ml pro Liter Badflüssigkeit. Durch eine weitere Erhöhung der Konzentration steigen die Kosten sehr stark an, ohne daß oberhalb dieses Grenzwertes noch ein besseres Ergebnis erzielt würde. Bei zu niedrigen Konzentrationen wird nicht der gesamte Feinkornzusatz emulgiert und bleibt deshalb weiterhin teilweise als Festsubstanz in der Lösung.

Die Komponenten Feinkomzusatz, Netzmittel und eventuell Emulgator haben bezüglich ihrer Konzentration und ihres Zusammenwirkens eine enge Beziehung zueinander, so daß es auf die richtige Auswahl in der passenden Konzentration ankommt. Außerdem ist noch eine Abstimmung auf die den pH-Wert einstellende Säurekonzentration nötig, um die Löslichkeit zu verbessern. Als Emulgator werden bevorzugt: Fettalkoholether, Nonylphenole, Ölsäureethoxylate, Alkylphenolethoxylate oder Sulfonpropylether. Besonders vorteilhaft ist es, als Emulgator denselben Stoff zu verwenden, der auch als Tensid benutzt wird. Bevorzugt wird hierbei ein Fettalkoholether verwendet.

Zur Einstellung es pH-Werts werden 50 bis 300 g pro Liter Badflüssigkeit einer Säure verwendet. Bevorzugt werden für den stark sauren Bereich Schwefel- oder Methansulfonsäure. Um eine höhere Zinnkonzentration in dem Austauschbad zu erhalten, wird jedoch Methansulfonsäure bevorzugt, da die Löslichkeit des Zinnsalzes in ihr höher liegt als bei Verwendung von Schwefelsäure. Dabei bildet sich Zinnmethansulfonat. Der pH-Wert des Austauschbades stellt sich, auf Grund der Vollständigkeit des in Lösung gehens mit der Säure, ein Wert ein, der unter 1 liegt.

Das erfindungsgemäße Bad kann bei Temperaturen zwischen 45° und 80° betrieben werden, vorzugsweise wird es bei einer Temperatur zwischen 60° und 75 °C betrieben. Am besten arbeitet es im Bereich zwischen 65° und 70° C. Höhere Temperaturen wirken sich zwar beschleunigend auf die Reaktion aus, jedoch nimmt auch die Bildung von Schwefel durch die Oxidation des Thiohamstoffs mit steigender Temperatur zu, so daß es dann verstärkt zu einer feinkristallinen Abscheidung von Schwefel kommen kann. Je kleiner die Temperatur ist, desto kleiner ist auch die Abscheiderate pro Zeit. Deshalb muß für die Temperatur ein sinnvoller Kompromiß gefunden werden, der sich vorzugsweise in den obengenannten Grenzen bewegt.

Eine vorteilhafte Weiterbildung der Erfindung sieht vor, daß dem Austauschbad eine Carbonsäure zugesetzt ist. Diese unterstützt den Thioharnstoff bzw. ein Derivat davon bei der Komplexierung des Kupfers. Dadurch wird die Lebensdauer des Bades verlängert, da mehr Kupfer komplexiert werden kann. Bevorzugt wird Zitronensäure verwendet, da sich dabei in vorteilhafter Art und Weise eine gleichmäßig helle Abscheidung ergibt, die einer fleckigen Abscheidung aus ästhetischen Gründen vorgezogen wird. Bevorzugt ist eine Konzentration von 50 - 200 g/l Badflüssigkeit.

Eine weitere vorteilhafte Weiterbildung der Erfindung sieht vor, daß dem Austauschbad ein Reduktionsmittel zugesetzt wird. Vorzugsweise wird unterphosphorige Säure oder Natriumhypophosphit verwendet, besonders bevorzugt ist jedoch Natriumhypophosphit. Dadurch wird die Aufoxidation des zweiwertigen Zinns durch Luftsauerstoff zu vierwertigem Zinn unterdrückt. Vierwertiges Zinn steht zum Austausch gegen Kupfer nicht mehr zur Verfügung, so daß seine Bildung vermieden werden muß.

Eine weitere vorteilhafte Weiterbildung der Erfindung sieht vor, daß dem Austauschbad eine Blei-II-Komponente zugesetzt wird. Vorzugsweise wird Bleiacetat in einer Konzentration von 5 - 40 mg pro Liter Badflüssigkeit verwendet. Dadurch wird in die Oberfläche des Kupfersubstrats nicht nur Zinn, sondern auch Blei eingebaut. Es ergibt sich somit an der Oberfläche eine Legierung aus Zinn und Blei. Im Gegensatz zur unerwünschten Bildung einer Zinn-Kupfer-Legierung, die die Lötbarkeit der Zinn-Schicht drastisch verschlechtern würde, wird die Lötbarkeit der Zinn-Schicht durch das Mitabscheiden von Blei verbessert. Außerdem wird durch den Bleizusatz in der Oberflächenschicht eine noch effektivere Sperrschicht gegen Kupfer aufgebaut, so daß noch weniger Kupfer an die Oberfläche diffundiert. Als weiterer Vorteil wird dadurch eine Whisker-Bildung vermieden. Hierbei handelt es sich um ein Einkristallwachstum des Zinns bei der Einlagerung von Leiterplatten, wobei sich von einem Leiterzug - meist senkrecht zu diesem - eine Querverbindung ausbildet, die zu einem Kurzschluß führt, wenn sie mit einem benachbarten Leiterzug in Verbindung kommt.

Mit zunehmendem Badalter nimmt die Kupferkonzentration im Austauschbad zu, da das Kupfer durch Zinn im Substrat ersetzt wird. Bei einer Kupferkonzentration von ungefähr 5 g pro Liter Badflüssigkeit sollte das Austauschbad verworfen werden, da mit zunehmender Kupferkonzentration eine zunehmend kupferreiche Kupfer-Zinn-Schicht abgeschieden wird, die zu Lötproblemen führt.

Bei einem erfindungsgemäßen Bad erhält man eine Abscheiderate von 0,8 bis 1,5 µm pro 20 Minuten.

Nachfolgend sind zwei Ausführungsbeispiele erfindungsgemäßer Austauschbäder angeführt, wobei kein Schwefel abgeschieden wird, da es zu keiner Zersetzung des Thioharnstoffs kommt.

### Ausführungsbeispiel 1

Eine bevorzugte Zusammensetzung eines erfindungsgemäßen Bades enthält folgende Konzentrationen pro Liter Badflüssigkeit:
- 20 g Zinn als Zinn-II-Sulfat
- 150 g Thioharnstoff
- 200 g Zitronensäure
- 2 g Benzalaceton
- 15 ml Fettalkoholether ethoxyliert
- 10 g 2-Thiohydantoin
- 20 mg Blei als Bleiacetat
- 30 g Natriumhypophosphit
- 230 g Schwefelsäure

Es stellt sich ein pH-Wert des Bades ein, der kleiner als 1 ist. Bei einer Betriebstemperatur von 70° C erreicht man in 10 min. eine Schichtstärke von 1,0 µm, wobei eine Schwankung möglich ist, die in erster Linie von der Kupfer-Reinheit des Substrats abhängt und ob es sich um ein stehendes oder fließendes Bad handelt. Mit einem solchen Bad bekommt man eine glatte, gleichmäßig helle Zinnschicht, wobei sich im Austauschbad über die gesamte Standzeit keine Schwefeltrübung einstellt und somit auch kein Schwefel in die Zinnschicht eingebaut wird. Anstatt des Benzalacetons und des ethoxylierten Fettalkohlethers kann auch 50 ml eines Glanzzusatzes, der ethoxylierte Fettalkohole in einer Konzentration von kleiner als 20 % und 4-Phenyl-3-buten-2-on in einer Konzentration von ca. 3 % in wässriger Lösung aufweist, verwendet werden. Ein solcher Glanzzusatz wird von der Fa. TH-GOLDSCHMIDT AG, Essen in Form ihres Produktes TEGO SPEEDPLATE PLUS vertrieben.

### Ausführungsbeispiel 2

Eine weitere bevorzugte Zusammensetzung eines erfindungsgemäßen Bades enthält pro Liter Badflüssigkeit:
- 6 g Zinn als Zinnmethansulfonat
- 130 g Thioharnstoff
- 200 g Zitronensäure
- 2 g Benzalaceton
- 15 ml Fettalkoholether etoxyliert
- 5 g 2-Thiohydantoin
- 10 mg Blei als Bleiacetat
- 10 g Natriumhypophosphit
- 140 g Methansulfonsäure

Es stellt sich ein pH-Wert ein, der kleiner als 1 ist. Zur Erzielung einer Schichtstärke von 1,0 µm muß das zu beschichtende Objekt bei einer Temperatur von 70° C 10 min. im Bad verweilen. Bei einer Temperatur von nur 50° C ist eine Verweildauer von 20 min. nötig um eine Zinn-Schichtstärke von 1 µm zu erhalten. Auch hier erhält man eine glatte, gleichmäßig helle Zinnschicht und es findet kein Schwefeleinbau in die abgeschiedene Zinnschicht statt, da auch dieses zweite Ausführungsbeispiel keine Schwefeltrübung aufweist.

### Stand der Technik

Zum Vergleich sind die Ergebnisse bei einem bekannten Austausch-Zinnbad unter gleichen Bedingungen angegeben:

Das bekannte Austauschzinnbad enthält 21,5 g/l Zinn (II) und wird ebenfalls bei einer Temperatur von 70° C betrieben. Nach einer Verweilzeit eines Kupfersubstrats von 9 Min. im Bad erhält man eine Zinn-Schichtstärke von 1 - 1,2 µm. Jedoch wird bei diesem Bad mit zunehmendem Badalter eine gelbliche Trübung durch Schwefel erkennbar, der in die Zinnschicht miteingebaut wird und somit zu einer Verschlechterung der Löteigenschaften dieser Zinnschicht führt. Außerdem leidet die Ausbildung der Diffusionsschichtstärke unter dem Schwefeleinbau. Dadurch wird ein kontinuierliches Filtern des Austauschbades nötig, was lästig und teuer ist. Mehr ist über dieses Austauschbad nicht bekannt.

## Patentansprüche

1. Wässriges, stark saures Austauschbad zum stromlosen Abscheiden von Zinn auf Kupfer, welches in 1 l Badflüssigkeit folgende Mengen an gelösten Stoffen enthält:
a) 5-30 g Zinn in Form eines Zinn-II-Salzes,
b) 50-200 g Thioharnstoff oder eines Thioharnstoffderivats,
c) 1-10 g 2-Thiohydantoin,
d) 0,5-2 g eines Feinkornzusatzes für das Sn,
e) 1-20 ml eines Emulgators für den Feinkornzusatz, wenn dieser nicht wasserlöslich ist, und
f) 1-20 ml eines Tensides.

2. Austauschbad nach Anspruch 1, **dadurch gekennzeichnet, daß** es sich bei dem Zinn-II-Salz um Zinn-II-Chlorid, -Sulfat oder Zinnmethansulfonat handelt.

3. Austauschbad nach Anspruch 1 oder 2, **dadurch gekennzeichnet, daß** dem Bad eine Carbonsäure, insbesondere Zitronensäure, in einem Bereich von 50-200 g/l zugesetzt ist.

4. Austauschbad nach einem der vorstehenden Ansprüche, **dadurch gekennzeichnet, daß** der Feinkornzusatz Benzalaceton, ein Benzalacetonderivat oder ein Imidazol ist.

5. Austauschbad nach Anspruch 4, **dadurch gekennzeichnet, daß** das Benzalacetonderivat Benzyliden-Diacetonol oder p-Chlorbenzyliden-Diacetonol ist.

6. Austauschbad nach Anspruch 4 oder 5, **dadurch gekennzeichnet, daß** der Emulgator für den Feinkornzusatz ein Fellalkoholether, ein Nonylphenol, ein Ölsäureethoxylat, ein Alkylphenolethoxylat oder ein Sulfonpropylether ist.

7. Austauschbad nach einem der vorstehenden Ansprüche, **dadurch gekennzeichnet, daß** das Tensid ein Fettalkoholether, ein Fettsäureamid, ein Ölsäureamidethoxylat, ein Alkylphenol oder ein Polyethylenglykol ist.

8. Austauschbad nach einem der Ansprüche 6 oder 7, **dadurch gekennzeichnet, daß** der Fettalkoholether ethoxyliert ist und eine Kohlenstoffkettenlänge von 10 bis 14 hat.

9. Austauschbad nach einem der vorstehenden Ansprüche, **dadurch gekennzeichnet, daß** zur Einstellung des pH-Wertes 50-300 g Schwefel- oder Methansulfonsäure zugesetzt ist.

10. Austauschbad nach einem der vorstehenden Ansprüche, **dadurch gekennzeichnet, daß** dem Bad ein Reduktionsmittel, wie z.B. Natriumhypophosphit oder unterphosphorige Säure, in einem Bereich von 5-50 g zugegeben ist.

11. Austauschbad nach einem der vorstehenden Ansprüche, **dadurch gekennzeichnet, daß** dem Bad Blei in Form einer Blei-II-Verbindung, insbesondere Bleiacetat, in einem Bereich von 5-40 mg zugegeben ist.

12. Austauschbad nach einem der vorstehenden Ansprüche, **dadurch gekennzeichnet, daß** als Emulgator und als Tensid derselbe Stoff verwendet wird.

## Claims

1. Highly acidic aqueous exchange bath for electroless deposition of tin on copper, containing the following quantities of solved substances in 1 litre of bath liquid:
a) 5 to 30 g of tin in the form of a tin-II salt;
b) 50 to 200 g of thiourea or of a derivative of thiourea;
c) 1 to 10 g of 2-thiohydantoin;
d) 0.5 to 2 g of a fine-grain additive to the Sn;
e) 1 to 20 ml of an emulsifying agent for the fine-grain additive if the latter is insoluble in water; and
f) 1 to 20 ml of a tenside.

2. The exchange bath as defined in Claim 1, **characterised in that** the tin-II salt is tin-II chloride, tin-II-sulphate or tin methane sulphonate.

3. The exchange bath as defined in Claim 1 or Claim 2, **characterised in that** a carbonic acid, especially citric acid, is added to the bath in a quantity range of 50 to 200 g/l.

4. The exchange bath as defined in any of the preceding claims, **characterised in that** the fine-grain additive is benzal acetone, a derivative of benzal acetone or an imide azole.

5. The exchange bath as defined in Claim 4, **characterised in that** the derivative of benzal acetone is benzylidene diacetonol or p-chlorobenzylidene diacetonol.

6. The exchange bath as defined in Claim 4 or Claim 5, **characterised in that** the emulsifying agent for the fine-grain additive is a fat alcohol ether, a nonyl phenol, an oleic acid ethoxylate, an alkyl phenol ethoxylate or a sulphone propyl ether.

7. The exchange bath as defined in any of the preceding claims, **characterised in that** the tenside is a fat alcohol ether, a fatty acid amide, an oleic acid amide ethoxylate, an alkyl phenol or a polyethylene glycol.

8. The exchange bath as defined in Claim 6 or Claim 7, **characterised in that** the fatty alcohol ether is ethoxylated and has a carbon chain length of 10 to 14.

9. The exchange bath as defined in any of the preceding claims, **characterised in that** 50 to 300 g of sulphuric acid or methane sulpho-acid are added for adjusting the pH value.

10. The exchange bath as defined in any of the preceding claims, **characterised in that** a reducing agent, for example sodium hypophosphite or hypophosphoric acid, are added to the bath in a quantity range of 5 to 50 g.

11. The exchange bath as defined in any of the preceding claims, **characterised in that** lead in the form a lead-II compound, especially lead acetate, is added to the bath in a quantity range of 5 to 40 mg.

12. The exchange bath as defined in any of the preceding claims, **characterised in that** one and the same substance is used as emulsifying agent and as tenside.

## Revendications

1. Bain d'échange aqueux fortement acide pour la précipitation sans courant d'étain sur du cuivre, qui contient, dans 1 litre de liquide du bain, les quantités ci-après de substances dissoutes :
a) de 5 à 30 g d'étain sous la forme d'un sel d'étain(II) ;
b) de 50 à 200 g de thiouréé ou d'un dérivé de thiourée ;
c) de 1 à 10 g de la 2-thiohydantoïne ;
d) de 0,5 à 2 g d'un additif à grains fins pour l'étain ;
e) de 1 à 20 ml d'un émulsifiant pour l'additif à grains fins, lorsque ce dernier n'est pas soluble dans l'eau ; et
f) de 1 à 20 ml d'un agent tensioactif.

2. Bain d'échange selon la revendication 1, **caractérisé en ce qu'**il s'agit, en ce qui concerne le sel d'étain(II) de chlorure d'étain(II), de sulfate d'étain(II) ou encore de méthanesulfonate d'étain.

3. Bain d'échange selon la revendication 1 ou 2, **caractérisé en ce qu'**on ajoute au bain un acide carboxylique, en particulier de l'acide citrique, dans la plage de 50 à 200 g/litre.

4. Bain d'échange selon l'une quelconque des revendications précédentes, **caractérisé en ce que** l'additif à grains fins est de la benzylidène-acétone, un dérivé de benzylidène-acétone ou encore un imidazole.

5. Bain d'échange selon la revendication 4, **caractérisé en ce que** le dérivé de benzylidène-acétone est la benzylidène-diacétonol ou le p-chlorobenzylidène-diacétonol.

6. Bain d'échange selon la revendication 4 ou 5, **caractérisé en ce que** l'émulsifiant pour l'additif à grains fins est un éther d'alcool gras, un nonylphénol, un éthoxylate d'acide oléique, un éthoxylate d'alkylphénol ou encore un éther propylique de sulfone.

7. Bain d'échange selon l'une quelconque des revendications précédentes, **caractérisé en ce que** l'agent tensioactif est un éther d'alcool gras, un amide d'acide gras, un éthoxylate d'amide d'acide oléique, un alkylphénol ou un polyéthylèneglycol.

8. Bain d'échange selon l'une quelconque des revendications 6 ou 7, **caractérisé en ce que** l'éther d'alcool gras est éthoxylé et possède une longueur de chaîne carbonée de 10 à 14.

9. Bain d'échange selon l'une quelconque des revendications précédentes, **caractérisé en ce que**, pour le réglage de la valeur de pH, on ajoute de l'acide sulfurique ou de l'acide méthanesulfonique à raison de 50 à 300 g.

10. Bain d'échange selon l'une quelconque des revendications précédentes, **caractérisé en ce qu'**on ajoute au bain, un agent de réduction tel que par exemple l'hypophosphite de sodium ou l'acide hypophosphorique, dans la plage de 5 à 50 g.

11. Bain d'échange selon l'une quelconque des revendications précédentes, **caractérisé en ce qu'**on ajoute au bain, du plomb sous la forme d'un composé de plomb(II), en particulier d'acétate de plomb, dans la plage de 5 à 40 mg.

12. Bain d'échange selon l'une quelconque des revendications précédentes, **caractérisé en ce qu'**on utilise la même substance à titre d'émulsifiant et à titre d'agent tensioactif.
